# EUROPEAN PATENT SPECIFICATION

(11) **EP 4 402 746 B1**
(45) Date of publication and mention of the grant of the patent: **24.09.2025**
(21) Application number: 22720082.1
(22) Date of filing: 26.04.2022
(51) Int. Cl.: H01P 1/208

(54) **INTEGRATED LOW-PASS AND BAND-PASS FILTER UNIT FORMED BY SHEET METAL COATED WITH DIELECTRIC MATERIAL**
INTEGRIERTE TIEFPASSFILTEREINHEIT MIT DIELEKTRISCHER BESCHICHTUNG AUS BLECH
UNITÉ DE FILTRE PASSE-BAS ET PASSE-BANDE INTÉGRÉE FORMÉE PAR UNE TÔLE REVÊTUE D'UN MATÉRIAU DIÉLECTRIQUE

(30) Priority: 14.09.2021 WO PCT/CN2021/118317
(43) Date of publication of application: 24.07.2024
(73) Proprietor: Telefonaktiebolaget LM Ericsson (publ), 164 83 Stockholm (SE)
(72) Inventor: FU, Jun, Beijing 100102 (CN); WANG, Weidong, Beijing 100102 (CN); ZHANG, Xueyuan, Beijing 100102 (CN)
(74) Representative: Ericsson
(86) International application number: PCT/SE2022/050401
(87) International publication number: WO 2023/043350

(56) References cited:
- WO-A1-2020/200318
- US-A1- 2011 241 801
- US-A1- 2013 093 539
- US-A1- 2014 340 169
- US-A1- 2019 280 358

## Description

### TECHNICAL FIELD

Embodiments herein relate to filters. In particular, they relate to integrated low-pass and band-pass filter unit formed by sheet metal coated with dielectric material.

### BACKGROUND

In the 5^{th} Generation (5G) communication, two types of frequency ranges have been defined, Frequency Range-1, i.e. Sub-6 GHz, which is less than 6GHz, and Frequency Range-2, i.e. millimeter wave, which is above 24GHz. With the development of the 5G communication, multiple-input and multiple-output (MIMO) technology is widely used in Sub-6 GHz base station product, in which amount of filter unites (FUs) need to be integrated with antenna unit (AU) or radio unit (RU). Considering cost and space saving, FUs are usually soldered onto radio unit mother board, Low-Pass Filter (LPF) board or antenna power splitter board, which means smaller and lighter FUs are quite in demand.

In traditional base station solutions, metal cavity FUs are most recommended because of their high Quality (Q) value and power handling performance. For 5G advanced radio system, the size and weight of FUs become critical issues. Ceramic waveguide (CWG) filters especially CWGs are one of the preferred FU solutions for 5G, due to their high performance, light weight, small size and easy integration. However, there are so many limitations of CWG FU, e.g., the Q value of a CWG filter is lower than a metal cavity filter, the size of a CWG filter needs to be limited to reduce the risk of being cracked when it is soldered onto a board since the ceramic material is easy to break if the size is too big, the high frequency suppression, i.e. the out of band frequency attenuation performance is relatively poor, etc. Due to those limitations, radio products which can use CWG filters are limited.

### SUMMARY

As a part of developing embodiments herein, problems and limitations with traditional CWG filters and metal FUs will further be discussed.

Traditional metal FUs have good performance and reliability. However, they have big size or volume and higher cost and are not a good solution for MIMO system.

One of the problems of the current CWG filters is bandwidth limitation. While a wideband radio product demands for wideband filters.

The Q value of a CWG filter is lower. To increase the Q value, the size of the cavity must be increased, and this contradicts with the basic design desire of smaller size.

CWG FUs also have limitation factors in production, which cannot be used in complex radio systems. They are also unreliable during long-term radio work progress. A CWG FU is always soldered with a Printed Circuit Board (PCB) LPF to get better out of band attenuation, the LPF will bring much loss and extra coupling from two near paths on the PCB.

Sheet metal FUs have good reliability in production, but they have worser power handling capacity and bigger size compared to CWG FUs. Sheet metal band pass filter (BPF) is usually combined with a sheet metal LPF to get better out of band attenuation, the sheet metal LPF has smaller insertion loss compared with the PCB LPF. WO202000318 refers to a filter unit with sheet metal in a cavity.

It is therefore an object of embodiments herein to provide a filter unit with improved radio performance, power handling capacity and reliability, and at the same time with reduced size and weight.

According to one aspect, the object is achieved by an integrated low-pass and band-pass filter unit. The integrated low-pass and band-pass filter unit comprises an inner cavity formed by a shell of conductive materials. The integrated low-pass and band-pass filter unit further comprises one or more low-pass resonators and two or more band-pass resonators comprised in the inner cavity. The low-pass and band-pass resonators are integrally formed by electroplated sheet metal material. A part of each of the low-pass and band-pass resonators is coated with dielectric material. The two or more band-pass resonators are arranged at two sides of the inner cavity such that at least two resonators are aligned to face each other.

The integrated low-pass and band-pass filter unit further comprises a first separator of electroplated sheet metal arranged in the inner cavity between the low-pass resonators and band-pass resonators and a second separator of electroplated sheet metal arranged in the inner cavity between the band-pass resonators at the two sides of the inner cavity.

The integrated low-pass and band-pass filter unit further comprises an input port to receive a signal to be filtered and an output port to output a filtered signal.

According to some embodiments herein, the integrated low-pass and band-pass filter unit may further comprise a first coupling structure of the dielectric material. The first coupling structure is arranged between the two resonators facing each other and the first coupling structure may be connected to the dielectric material coated part of the one resonator or to the dielectric material coated parts of both resonators.

In other words, according to the embodiments herein, to solve the contradiction between the high Q-factor and small size of a filter, an integrated low-pass and band-pass filter unit formed by sheet metal coated with dielectric material is provided.

The integrated low-pass and band-pass filter unit according to embodiments herein have some advantages, for examples:
- The volume is smaller and lighter compare with the traditional metal filters. Using the dielectric material, e.g. plastic, coated sheet metal resonators can effectively reduce the resonance frequency of the resonator in order to reduce the size of the resonator. In turn, the size of the cavity containing the resonator is reduced, and as the result, the size of the whole filter is reduced.
- The dielectric material's dielectric constant is higher than air, a part of the electric field of the resonator is constraint in the dielectric coated boundary, therefore, the maximum field intensity of a single cavity is relatively lower, which can significantly improve the power handling capacity of the integrated low-pass and band-pass filter unit.
- The integrated low-pass and band-pass filter unit may be moulded by pressing and bending in the production process, and then plastic injection moulding is used to cover the resonators. This production process improves the tolerance level of the resonators and the consistency of the RF performance compared to the traditional process with soldering or screwing tightly to form metal filter units.
- Both negative and positive coupling structures may be introduced in the integrated low-pass and band-pass filter unit. The upper half of the two plastic coated resonators facing each other may be filled with plastic to form strong negative coupling. The negative coupling may be adjusted freely by adjusting the size of the connecting plastic or by loading screws. Therefore, the proposed coupling structures make the cross-coupling easier to be controlled. Negative coupling and positive coupling can be more flexible established, routed and placed.
- The design of the integrated low-pass and band-pass filter unit can be flexible according to different specifications of radio performance. The number of resonators of low-pass and band-pass may be adjusted according to radio performance requirement.
- The integrated low-pass and band-pass filter unit is more flexible in design for macro base station and may be used for indoor small base station and traditional macro base station and has advantage in production and cost.
- The low-pass filter is integrated on the sheet metal with the band-pass filter and can provide a strong suppression for radio frequency signals in 8GHz-18GHz.

Therefore, embodiments herein provide a filter unit with improved radio performance, power handling capacity and reliability, and at the same time with reduced size and weight.

### BRIEF DESCRIPTION OF THE DRAWINGS

Examples of embodiments herein are described in more detail with reference to attached drawings in which:
- Figure 1a: shows an example of a flat expansion of the metal sheet of a low-pass filter and band-pass filter according to embodiments herein;
- Figure 1b: shows some example shapes of resonators according to embodiments herein;
- Figure 2: shows a view of an example main body of an integrated low-pass and band-pass filter unit according to embodiments herein;
- Figure 3: shows a view of an example main body of the integrated low-pass and band-pass filter unit where parts of the resonators are coated with dielectric material according to embodiments herein;
- Figure 4a: shows a view of an example structure of an integrated low-pass and band-pass filter unit according to embodiments herein;
- Figure 4b: is a top view of the integrated low-pass and band-pass filter unit shown in Figure 4;
- Figure 4c: shows another view of an example structure of an integrated low-pass and band-pass filter unit according to embodiments herein;
- Figure 4d: shows a view of an example loading screw placed in the integrated low-pass and band-pass filter unit shown in Figure 4c according to embodiments herein;
- Figure 4e: shows a view of another example loading screw placed in the integrated low-pass and band-pass filter unit shown in Figure 4a according to embodiments herein;
- Figure 5a: is a simplified top view of the distribution of electric field in a single cavity of a metal resonator;
- Figure 5b: is a simplified top view of the distribution of negative coupling electric field between two sheet metal resonators;
- Figure 6: shows one example structure of two resonators facing each other with positive and negative couplings according to embodiments herein;
- Figure 7: shows S-parameter simulation results for the integrated low-pass and band-pass filter unit according to embodiments herein;
- Figure 8: shows simulation results of out-of-band high frequency suppression performance for the integrated low-pass and band-pass filter unit according to embodiments herein; and
- Figure 9: is a block diagram illustrating a device in which the integrated low-pass and band-pass filter unit according to embodiments herein may be implemented.

### DETAILED DESCRIPTION

According to embodiments herein, to solve the contradiction between the Q-factor and size of a filter, an integrated low-pass and band-pass filter unit with low-pass and band-pass function formed by sheet metal materials and parts of the sheet metal materials being dielectric material-coated is provided.

The integrated low-pass and band-pass filter unit according to the embodiments herein comprises a main body comprising a low-pass filter comprising one or more low-pass resonators and a band-pass filter comprising two or more band-pass resonators. The low-pass and band-pass resonators are integrally formed by electroplated sheet metal material. To reduce the size of the main body, parts of the metal sheet resonators can be coated with dielectric material.

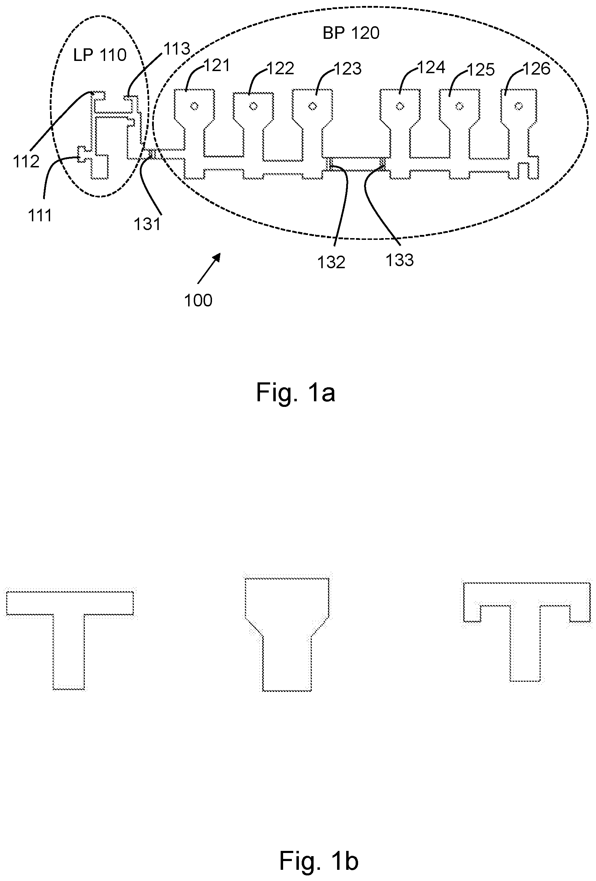

**Figure 1a** shows a flat expansion of a low-pass (LP) filter **LP 110** and band-pass (BP) filter **BP 120** integrally formed by a sheet of metal material **100.**The sheet metal material may be electroplated sheet metal. The low-pass and band-pass filters LP 110, BP 120 may be formed by sheet metal wire cutting, molding or stamping processing.

Figure 1 is only for illustrating purpose and shows example structures of the low-pass and band-pass filters LP 110, BP 120 integrally formed by a sheet of metal. It is shown in Figure 1, the low-pass filter LP 110 comprises 3 LP resonators **111, 112, 113** and the band-pass filter BP 120 comprises 6 BP resonators **121, 122, 123, 124, 125, 126.** However, the number and shape of the low-pass and band-pass resonators may vary depending on different application scenarios. The number of resonators is related to the performance of the filter. The more the number of filter resonators, the better the out-of-band suppression, but the worse the insertion loss. **Figure 1b** shows some example shapes of resonators.

The flat metal sheet of the low-pass and band-pass filters LP 110, BP 120 is bent to form the main body of the integrated low-pass and band-pass filter unit. For example, the flat metal sheet of the low-pass and band-pass resonators 111, 112, 113, 121, 122, 123, 124, 125, 126 may be bent at the positions **131, 132, 133** shown in Figure 1 by bending processing in production.

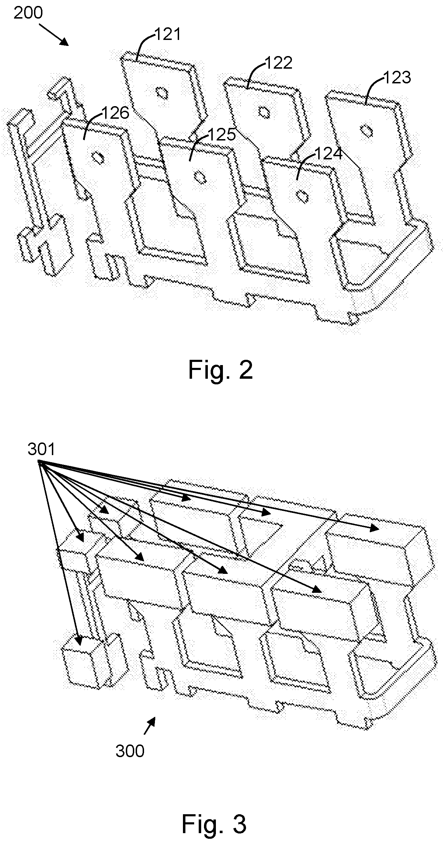

**Figure 2** shows the main body **200** of the integrated low-pass and band-pass filter unit after the bending process is performed on the flat metal sheet of the low-pass and band-pass resonators 111, 112, 113, 121, 122, 123, 124, 125, 126 shown in Figure 1. In this example, the band-pass resonators 121, 122, 123, 124, 125, 126 have been formed to a symmetrical structure after the bending processing performed at the bending positions 132, 133 shown in Figure 1. The six band-pass resonators 121, 122, 123, 124, 125, 126 have been arranged and aligned at two sides, and each side comprises 3 resonators. As can be seen from Figure 2, there are 3 pairs of aligned resonators facing to each other. For example, the BP resonators 121 and 126 is a pair of aligned resonators facing each other, the BP resonators 122 and 125 is a pair of aligned resonators facing each other, and the BP resonators 123 and 124 is a pair of aligned resonators facing each other.

The bending positions may be chosen at other places than what are shown in Figure 1 according to different application scenarios. Then, the band-pass resonators 121, 122, 123, 124, 125, 126 may be formed to a non-symmetrical structure, for example, one side comprises 2 resonators, and the other side comprises 4 resonators, and there are two pairs of aligned resonators facing each other. The bending positions may be chosen freely.

**Figure 3** shows the main body **300** of the integrated low-pass and band-pass filter unit where a part of each of the low-pass and band-pass resonators is coated with dielectric material, indicated by **301.** The dielectric material may be plastic, other polymer materials or ceramic.

For the same Q value, the lower the frequency, the larger the volume of a single cavity of a resonator. The resonant frequency of a resonator is the frequency at which the energy of the stored electric field equals that of the stored magnetic field. The plastic-coated high dielectric material makes the electric field energy and magnetic field energy mostly concentrated near the resonator and equal to the electromagnetic field energy at lower frequencies. Therefore using the dielectric material coated sheet metal resonators can effectively reduce the resonance frequency of the resonator in order to reduce the size of the resonator. As a result, the size of a single cavity of a resonator and in turn, the size of the whole filter unit composed of several single cavities can be reduced.

Since the dielectric constant of the dielectric material, e.g., plastic, is higher than air, a part of the electric field generated by a resonator is constraint within the plastic boundary. Therefore, the maximum electric field intensity of a single cavity containing the resonators is relatively lower, which can significantly improve the power handling capacity of the filter unit.

Materials with the dielectric constant of 1.8~10 are preferred. In actual use, materials with Dielectric Loss Angle lower than one thousandth are preferred based on the insertion loss characteristics of the filter. Dielectric Loss Angle is the phase difference between the electric field vector and the electric displacement in a dielectric material. This phase difference is caused by energy losses in the dielectric.

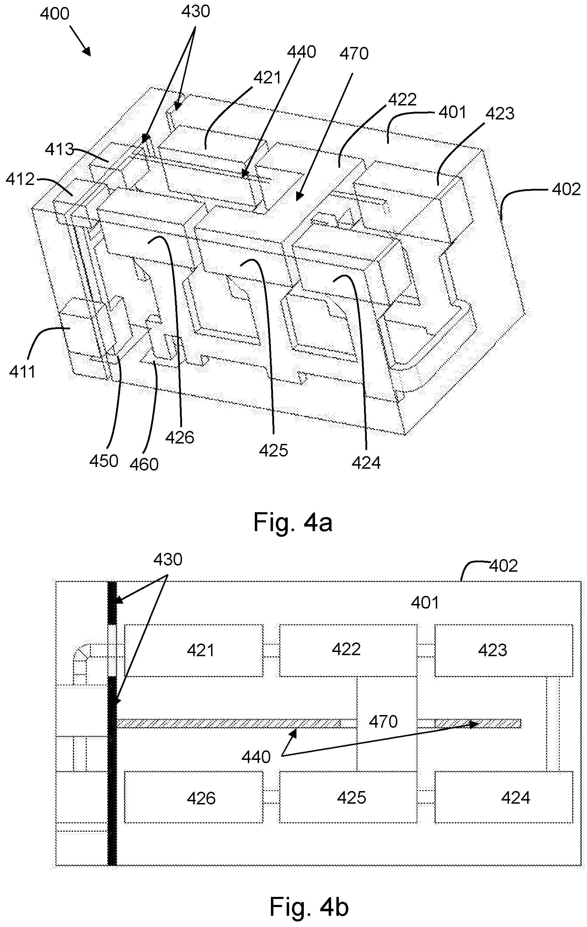

The main body 300 is placed in a shell to form a complete filter. **Figure 4a** shows an example structure of a complete integrated low-pass and band-pass filter unit **400** according to the embodiments herein. The main body 300, i.e., the dielectric material coated low-pass and band-pass resonators, is contained in an inner cavity **401** formed by a shell **402** of conductive materials. The shell 402 can be made up of any combination of profile, bending sheet metal and flat sheet metal.

The integrated low-pass and band-pass filter unit 400 according to the embodiments herein comprises the inner cavity 401, one or more low-pass resonators **411, 412, 413** and two or more band-pass resonators **421, 422, ...426** comprised in the inner cavity **401.** The low-pass and band-pass resonators 411, 412, 413, 421, ...426 are integrally formed by electroplated sheet metal material. A part of each of the low-pass and band-pass resonators 411, 412, 413, 421, ...426 is coated with dielectric material.

The two or more band-pass resonators 421, ...426 are arranged at two sides of the inner cavity 401 such that at least two resonators, e.g. band-pass resonators 422, 425, are aligned to face each other.

The integrated low-pass and band-pass filter unit 400 further comprises a first separator **430** of electroplated sheet metal arranged in the inner cavity 401 between the low-pass resonators 411, 412, 413 and band-pass resonators 421,...426 to separate the spatial between the low-pass resonators 411, 412, 413 and band-pass resonators 421,...426.

The integrated low-pass and band-pass filter unit 400 further comprises a second separator **440** of electroplated sheet metal arranged in the inner cavity 401 between the band-pass resonators at the two sides of the cavity 401 to separate the spatial between the two sides of the band-pass resonators.

The integrated low-pass and band-pass filter unit 400 further comprises an input port **450** to receive a signal to be filtered and an output port **460** to output a filtered signal.

According to embodiments herein, a negative coupling structure may be introduced in the integrated low-pass and band-pass filter unit 400. For example, the upper half of the two plastic-coated resonators facing each other may be filled with plastic to form strong negative coupling.

Therefore, according to some embodiments herein, the integrated low-pass and band-pass filter unit 400 may further comprise a first coupling structure **470** of the dielectric material. The first coupling structure 470 may be arranged between two BP resonators facing each other, e.g. between the BP resonators 422 and 425. The first coupling structure 470 may be connected to the dielectric material coated parts of both resonators, as shown in Figure 4a.

**Figure 4b** is a schematic top view of the integrated low-pass and band-pass filter unit 400 to give a clearer view of the first and second separators 430, 440 and the negative coupling structure 470.

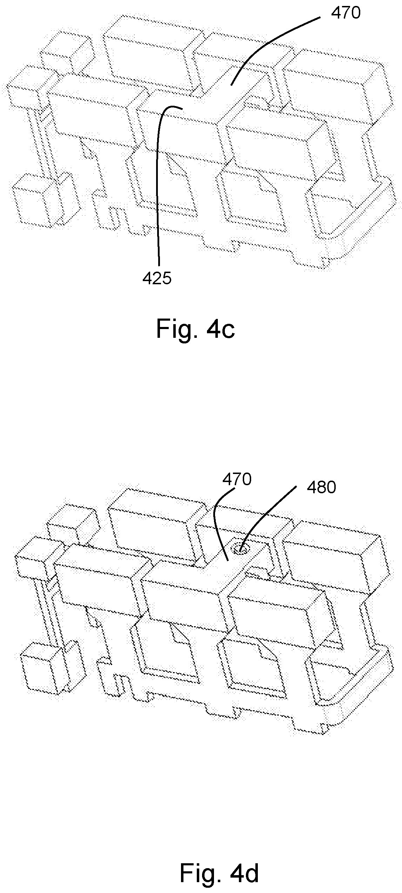

The first coupling structure 470 may also be connected only to the dielectric material coated part of one of the two facing BP resonators, e.g. the first coupling structure 470 is only connected to the BP resonator 425, as shown in **Figure 4c****.**

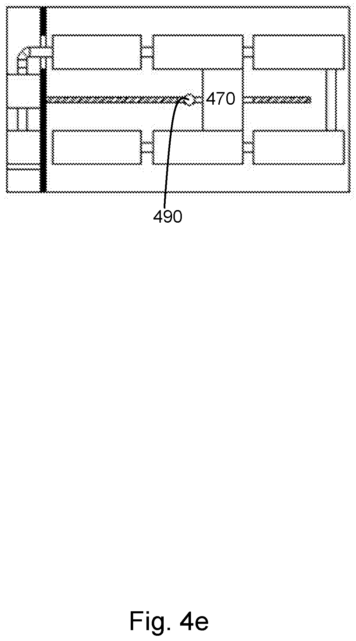

The negative coupling occurs at the top of the resonators. Therefore, the first coupling structure 470 is a negative coupling structure. The negative coupling changes with the size and shape of the coupling structure 470. Thus, the negative coupling may be adjusted freely by adjusting the size and/or the shape of the coupling structure 470. The negative coupling may also be adjusted by a loading screw **480** placed at the middle of the coupling structure 470 as shown in **Figure 4d** or a loading screw **490** placed at the side of the coupling structure 470 as shown in **Figure 4e****.**

The first coupling structure 470 of the dielectric material is paced at the top of the two resonators facing each other such that a negative coupling between the two resonators is achieved as a result of directions of the electric fields generated by the two resonators being opposite.

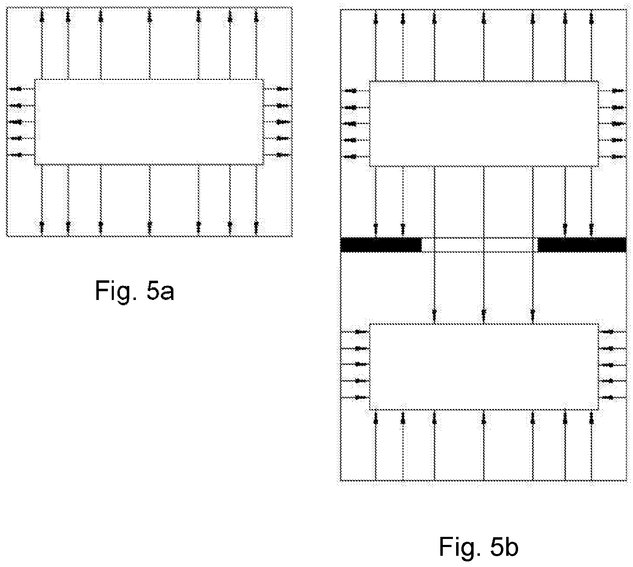

**Figure 5a** is a simplified top view of the distribution of electric field in a single cavity of a single sheet metal resonator. The arrows represent the direction of electric field generated by the resonator. Generally, when there is negative coupling between two sheet metal resonators, the direction of electric field in a single cavity of one sheet metal resonator must be opposite to that in another single cavity of another sheet metal resonator. **Figure 5b** is a simplified top view of the typical distribution of negative coupling electric field between two sheet metal resonators. As it can be seen, the directions of the electric fields generated by the two resonators are opposite.

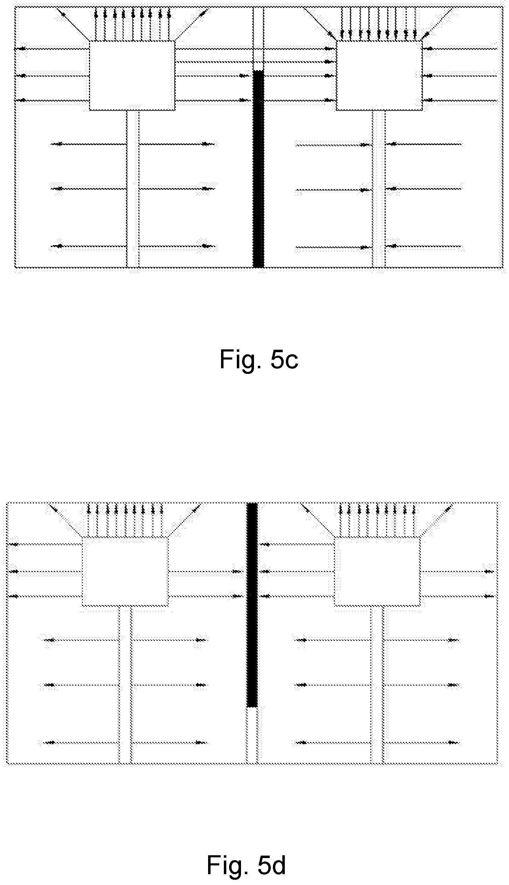

**Figure 5c** is a simplified side view of the distribution of electric fields between two sheet metal resonators. The coupling window is at the top of the resonators. After the coupling of the two resonators, the directions of the electric fields of the two resonators are completely opposite. This coupling is called negative coupling.

**Figure 5d** is a simplified side view of the distribution of electric fields between two sheet metal resonators. The coupling window is at the bottom of the resonators. After the coupling of the two resonators, the electric field directions of the two resonators are the same. This coupling is called positive coupling.

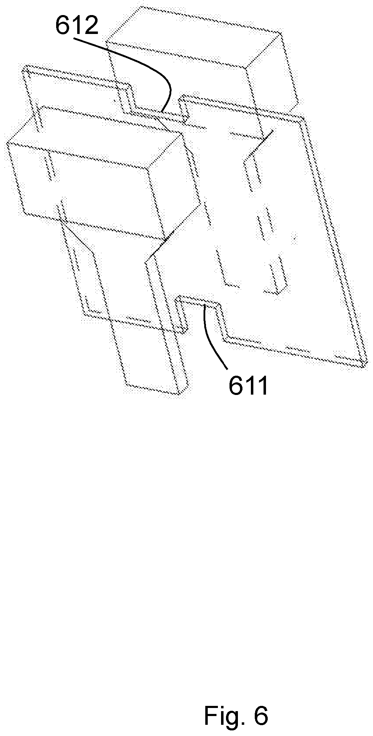

When positive coupling occurs between two resonators, the direction of electric field in one single cavity of one resonator will generally be the same as that in another single cavity of another resonator. When the plastic-coated position is at the bottom of the two resonators, the coupling of the resonators will produce positive coupling, and the coupling strength varies with the change of the coupling window. **Figure 6** shows an example structure of a positive coupling window 611 placed at the bottom of the resonators and a negative coupling window 612 placed at the top of the resonators.

Therefore, according to some embodiments herein, the integrated low-pass and band-pass filter unit 400 may further comprises a second coupling structure **611.** The second coupling structure 611 may be paced at the bottom of two resonators such that a positive coupling between the two resonators is achieved as a result of directions of electric fields generated by the two resonators being the same.

The positive coupling may be achieved by a coupling structure between two resonators facing each other or any two neighbor resonators at the same side of the inner cavity 401. Generally, between the bottom and upper of a resonator, For examples, an open window structure 611, a coupling structure of dielectric material, a direct metal bar connection etc. all are positively couplings.

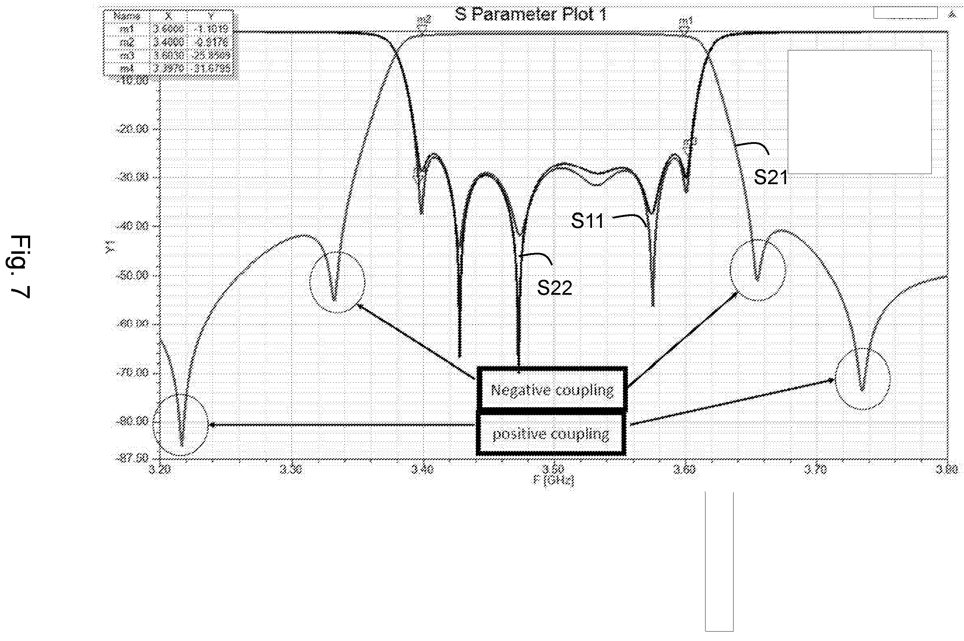

**Figure 7** is diagram showing simulation results of S-parameter, input-to-input **S11,** output-to-input **S21,** and output-to-output **S22** curves for a typical use case of the integrated low-pass and band-pass filter unit 400. It can be seen from the structure of the integrated low-pass and band-pass filter unit 400 that the filter produces negative coupling between the second and fifth resonators resulting two first-order zeros and positive coupling in the first and sixth resonators resulting two second-order zeros for the band-pass filter.

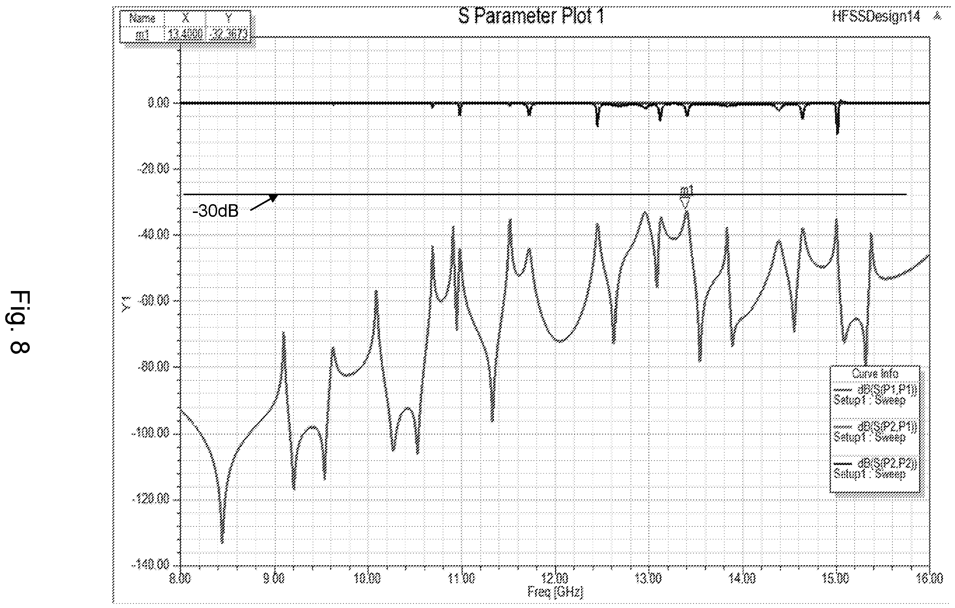

**Figure 8** is diagram showing out-of-band suppression performance at high frequencies of the integrated low-pass and band-pass filter unit 400, which is over -30dB in the high frequency region of 8 Ghz-16Ghz.

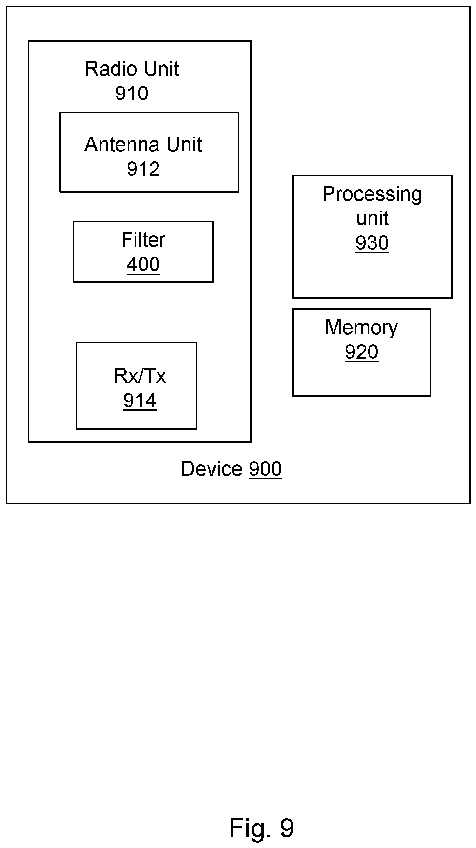

The integrated low-pass and band-pass filter unit 400 according to the embodiments herein may be employed in various electronic devices or any devices or apparatus where filtering radio frequency signals is needed. **Figure 9** shows a block diagram for a device **900.** The device 900 may comprise a radio unit **910,** which may comprise an antenna unit **912,** a transmitter, a receiver or both, i.e. a transceiver **Rx/Tx 9140** etc. The device 900 comprises the integrated low-pass and band-pass filter unit 400. The integrated low-pass and band-pass filter unit 400 may be comprised in the radio unit 910, in the antenna unit 912, or in the transceiver Rx/Tx 914. The device 900 may comprise other units, where a memory **920,** a processing unit **930** are shown. The device 900 may be a radio base station or micro base station for a cellular communication system or any device where a filter is needed for filtering radio frequency signals.

One or more integrated low-pass and band-pass filter units 400 may also form a multiband filter unit and employed in various electronic devices or any devices or apparatus where filtering radio frequency signals is needed.

To summarize, according to the embodiments herein, an integrated low-pass and band-pass filter unit 400 formed by sheet metal coated with dielectric material is provided and has some advantages, for examples:
- Reduced size and weight for radio unit using the integrated low-pass and band-pass filter unit 400. The volume is smaller and lighter compare with the traditional metal filters. Using the dielectric material, e.g. plastic, coated sheet metal resonators can effectively reduce the resonance frequency of the resonator in order to reduce the size of the resonator. In turn, the size of the cavity containing the resonator is reduced, and as the result, the size of the whole filter is reduced.
- Solving the design contradiction between the Q value and size of a filter.
- Getting better reliability while reducing the size of the filter.
- Realizing complex multiband FUs.
- Getting better power handling capacity with small size or volume. The dielectric material's dielectric constant is higher than air, a part of the electric field of the resonator is constraint in the dielectric coated boundary, therefore, the maximum field intensity of a single cavity is relatively lower, which can significantly improve the power handling capacity of the integrated low-pass and band-pass filter unit.
- Realizing better out of band attenuation and getting better insertion loss compared with PCB LPF. The low-pass filter is integrated on the sheet metal with the band-pass filter and can provide a strong suppression for radio frequency signals in 8GHz-18GHz. Easy to get wide bandwidth and better harmonic attenuation.
- Providing flexible assembling solution for filters, as well as high level building practice solutions, e.g. the integrated low-pass and band-pass filter unit 400 may be soldered on PCB, or use screw fasten solution by the metal part when connecting with other function units.
- The integrated low-pass and band-pass filter unit may be moulded by pressing and bending in the production process, and then plastic injection moulding may be used to cover the resonators. This production process improves the tolerance level of the resonators and the consistency of the RF performance compared to the traditional process with soldering or screwing tightly to form metal filter units.
- Both negative and positive coupling structures may be introduced in the integrated low-pass and band-pass filter unit. The upper half of the two plastic coated resonators facing each other may be filled with plastic to form strong negative coupling. The negative coupling may be adjusted freely by adjusting the size of the connecting plastic or by loading screws. Therefore, the proposed coupling structures make the cross-coupling easier to be controlled. Negative coupling and positive coupling can be more flexible established, routed and placed.
- The design of the integrated low-pass and band-pass filter unit can be flexible according to different specifications of radio performance. The number of resonators of low-pass and band-pass may be adjusted according to radio performance requirement.
- Good performance with appropriate cost. The integrated low-pass and band-pass filter unit is more flexible in design for macro base station and may be used for indoor small base station and traditional macro base station and has advantage in production and cost.

The word "comprise" or "comprising", when used herein, shall be interpreted as nonlimiting, i.e. meaning "consist at least of".

The embodiments herein are not limited to the above described preferred embodiments. Various alternatives, modifications and equivalents may be used. Therefore, the above embodiments should not be taken as limiting the scope of the invention, which is defined by the appended claims.

## Claims

1. An integrated low-pass and band-pass filter unit (400) comprising:
an inner cavity (401) formed by a shell (402) of conductive materials;
one or more low-pass resonators (411, 412, 413) and two or more band-pass resonators (421, 422, ...426) comprised in the inner cavity (401), wherein the low-pass and band-pass resonators (411, 412, 413, 421, 422, ...426) are integrally formed by electroplated sheet metal material, and a part of each of the low-pass and band-pass resonators (411, 412, 413, 421, 422, ...426) is coated with dielectric material, and wherein the two or more band-pass resonators (421, 422, ...426) are arranged at two sides of the inner cavity (401) such that at least two resonators are aligned to face each other;
a first separator (430) of electroplated sheet metal arranged in the inner cavity (401) between the low-pass resonators (411, 412, 413) and band-pass resonators (421, 422, ...426);
a second separator (440) of electroplated sheet metal arranged in the inner cavity (401) between the band-pass resonators at the two sides of the inner cavity 401;
an input port (450) to receive a signal to be filtered; and
an output port (460) to output a filtered signal.

2. The integrated low-pass and band-pass filter unit (400) according to claim 1, wherein the dielectric material is plastic, other polymer materials, or ceramic.

3. The integrated low-pass and band-pass filter unit (400) according to any one of claims 1-2, wherein the integrated low-pass and band-pass filter unit (400) further comprises a first coupling structure (470) of the dielectric material, and wherein the first coupling structure (470) is arranged between the two resonators facing each other, the first coupling structure (470) is connected to the dielectric material coated part of the one resonator (425) or to the dielectric material coated parts of both resonators (422, 425).

4. The integrated low-pass and band-pass filter unit (400) according to claim 3, wherein the first coupling structure (470) of the dielectric material is paced at the top of the two resonators (422, 425) facing each other such that a negative coupling between the two resonators is achieved as a result of directions of electric fields generated by the two resonators (422, 425) being opposite.

5. The integrated low-pass and band-pass filter unit (400) according to any one of claims 1-4, wherein the integrated low-pass and band-pass filter unit (400) further comprises a second coupling structure (611), wherein the second coupling structure (611) is paced at the bottom of two resonators such that a positive coupling between the two resonators is achieved as a result of directions of electric fields generated by the two resonators being the same.

6. A multiband filter unit comprising one or more integrated low-pass and band-pass filter units (400) according to any one of claims 1-5.

7. An antenna unit (912) comprising one or more integrated low-pass and band-pass filter units (400) according to any one of claims 1-5.

8. A radio unit (910) comprising one or more integrated low-pass and band-pass filter units (400) according to any one of claims 1-5.

9. A device (900) comprising one or more integrated low-pass and band-pass filter units (400) according to any one of claims 1-5.

10. The device (900) according to claim 9, wherein the device is a base station or micro base station for a cellular communication system.

## Patentansprüche

1. Integrierte Tiefpass- und Bandpassfiltereinheit (400), umfassend:
einen Innenhohlraum (401), der durch eine Hülle (402) aus leitfähigen Materialien ausgebildet ist;
einen oder mehrere Tiefpassresonatoren (411, 412, 413) und zwei oder mehr Bandpassresonatoren (421, 422, ..., 426), die in dem Innenhohlraum (401) umfasst sind, wobei die Tiefpass- und Bandpassresonatoren (411, 412, 413, 421, 422, ..., 426) durch ein elektroplattiertes Blechmaterial einstückig ausgebildet sind und ein Teil jedes der Tiefpass- und Bandpassresonatoren (411, 412, 413, 421, 422, ..., 426) mit dielektrischem Material beschichtet ist, und wobei die zwei oder mehr Bandpassresonatoren (421, 422, ..., 426) an zwei Seiten des Innenhohlraums (401) angeordnet sind, sodass die mindestens zwei Resonatoren so ausgerichtet sind, dass sie einander zugewandt sind;
einen ersten Separator (430) aus elektroplattiertem Blech, der in dem Innenhohlraum (401) zwischen den Tiefpassresonatoren (411, 412, 413) und den Bandpassresonatoren (421, 422, ..., 426) angeordnet ist;
einen zweiten Separator (440) aus elektroplattiertem Blech, der in dem Innenhohlraum (401) zwischen den Bandpassresonatoren an den zwei Seiten des Innenhohlraums (401) angeordnet ist;
einen Eingangsanschluss (450) zum Empfangen eines zu filternden Signals;
einen Ausgangsanschluss (460) zum Ausgeben eines gefilterten Signals.

2. Integrierte Tiefpass- und Bandpassfiltereinheit (400) nach Anspruch 1, wobei es sich bei dem dielektrischen Material um Kunststoff, andere Polymermaterialien oder Keramik handelt.

3. Integrierte Tiefpass- und Bandpassfiltereinheit (400) nach einem der Ansprüche 1-2, wobei die integrierte Tiefpass- und Bandpassfiltereinheit (400) ferner eine erste Kopplungsstruktur (470) des dielektrischen Materials umfasst und wobei die erste Kopplungsstruktur (470) zwischen den zwei Resonatoren angeordnet ist, die einander zugewandt sind, wobei die erste Kopplungsstruktur (470) mit dem mit dielektrischem Material beschichteten Teil des einen Resonators (425) oder den mit dielektrischem Material beschichteten Teilen beider Resonatoren (422, 425) verbunden ist.

4. Integrierte Tiefpass- und Bandpassfiltereinheit (400) nach Anspruch 3, wobei die erste Kopplungsstruktur (470) des dielektrischen Materials an der Oberseite der zwei Resonatoren (422, 425) platziert ist, die einander zugewandt sind, so dass zwischen den zwei Resonatoren als Ergebnis dessen, dass Richtungen von elektrischen Feldern, die von den zwei Resonatoren (422, 425) erzeugt werden, entgegengesetzt sind, eine negative Kopplung erreicht wird.

5. Integrierte Tiefpass- und Bandpassfiltereinheit (400) nach einem der Ansprüche 1-4, wobei die integrierte Tiefpass- und Bandpassfiltereinheit (400) ferner eine zweite Kopplungsstruktur (611) umfasst, wobei die zweite Kopplungsstruktur (611) an der Unterseite von zwei Resonatoren platziert ist, so dass zwischen den zwei Resonatoren als Ergebnis dessen, dass Richtungen von elektrischen Feldern, die von den zwei Resonatoren erzeugt werden, gleich sind, eine positive Kopplung erreicht wird.

6. Mehrbandfiltereinheit, umfassend eine oder mehrere integrierte Tiefpass- und Bandpassfiltereinheiten (400) nach einem der Ansprüche 1-5.

7. Antenneneinheit, (912), umfassend eine oder mehrere integrierte Tiefpass- und Bandpassfiltereinheiten (400) nach einem der Ansprüche 1-5.

8. Funkeinheit (910), umfassend eine oder mehrere integrierte Tiefpass- und Bandpassfiltereinheiten (400) nach einem der Ansprüche 1-5.

9. Vorrichtung (900), umfassend eine oder mehrere integrierte Tiefpass- und Bandpassfiltereinheiten (400) nach einem der Ansprüche 1-5.

10. Vorrichtung (900) nach Anspruch 9, wobei die Vorrichtung eine Basisstation oder eine Mikrobasisstation für ein zellulares Kommunikationssystem ist.

## Revendications

1. Unité de filtre passe-bas et passe-bande intégrée (400) comprenant :
une cavité intérieure (401) formée par une coque (402) de matériaux conducteurs ;
un résonateur passe-bas (411, 412, 413) ou plus et deux résonateurs passe-bande (421, 422, ... 426) ou plus compris dans la cavité intérieure (401), dans laquelle les résonateurs passe-bas et passe-bande (411, 412, 413, 421, 422, ... 426) sont formés intégralement de matériau de tôle galvanisée, et une partie de chacun des résonateurs passe-bas et passe-bande (411, 412, 413, 421, 422, ... 426) est revêtue de matériau diélectrique, et dans laquelle les deux résonateurs passe-bande (421, 422, ... 426) ou plus sont agencés au niveau de deux côtés de la cavité intérieure (401) de sorte qu'au moins deux résonateurs soient alignés pour se faire face ;
un premier séparateur (430) de tôle galvanisée agencé dans la cavité intérieure (401) entre les résonateurs passe-bas (411, 412, 413) et les résonateurs passe-bande (421, 422, ... 426) ;
un deuxième séparateur (440) de tôle galvanisée agencé dans la cavité intérieure (401) entre les résonateurs passe-bande au niveau des deux côtés de la cavité intérieure (401) ;
un orifice d'entrée (450) pour recevoir un signal à filtrer ; et
un orifice de sortie (460) pour délivrer un signal filtré.

2. Unité de filtre passe-bas et passe-bande intégrée (400) selon la revendication 1, dans laquelle le matériau diélectrique est du plastique, d'autres matériaux polymères ou de la céramique.

3. Unité de filtre passe-bas et passe-bande intégrée (400) selon la revendication 1 ou 2, dans laquelle l'unité de filtre passe-bas et passe-bande intégrée (400) comprend en outre une première structure de couplage (470) du matériau diélectrique, et dans laquelle la première structure de couplage (470) est agencée entre les deux résonateurs se faisant face, la première structure de couplage (470) est reliée à la partie revêtue de matériau diélectrique du résonateur (425) ou aux parties revêtues de matériau diélectrique des deux résonateurs (422, 425).

4. Unité de filtre passe-bas et passe-bande intégrée (400) selon la revendication 3, dans laquelle la première structure de couplage (470) du matériau diélectrique est placée au sommet des deux résonateurs (422, 425) se faisant face de manière à obtenir un couplage négatif entre les deux résonateurs par le fait que des directions de champs électriques générés par les deux résonateurs (422, 425) sont opposées.

5. Unité de filtre passe-bas et passe-bande intégrée (400) selon l'une quelconque des revendications 1 à 4, dans laquelle l'unité de filtre passe-bas et passe-bande intégrée (400) comprend en outre une deuxième structure de couplage (611), dans laquelle la deuxième structure de couplage (611) est placée au bas de deux résonateurs de manière à obtenir un couplage positif entre les deux résonateurs par le fait que des directions de champs électriques générés par les deux résonateurs sont les mêmes.

6. Unité de filtre multibande comprenant une ou plusieurs unités de filtre passe-bas et passe-bande intégrées (400) selon l'une quelconque des revendications 1 à 5.

7. Unité d'antenne (912) comprenant une ou plusieurs unités de filtre passe-bas et passe-bande intégrées (400) selon l'une quelconque des revendications 1 à 5.

8. Unité radio (910) comprenant une ou plusieurs unités de filtre passe-bas et passe-bande intégrées (400) selon l'une quelconque des revendications 1 à 5.

9. Dispositif (900) comprenant une ou plusieurs unités de filtre passe-bas et passe-bande intégrées (400) selon l'une quelconque des revendications 1 à 5.

10. Dispositif (900) selon la revendication 9, dans lequel le dispositif est une station de base ou une microstation de base pour un système de communication cellulaire.
